Europäisches Patentamt

European Patent Office

Office européen des brevets

(11) Publication number: **0 294 989**
**A2**

## EUROPEAN PATENT APPLICATION

(21) Application number: 88304961.1

(22) Date of filing: 01.06.88

(51) Int. Cl.4: **H01L 29/78** , //G11C17/00

(30) Priority: 12.06.87 JP 146332/87

(43) Date of publication of application:
**14.12.88 Bulletin 88/50**

(84) Designated Contracting States:
**DE FR GB**

(71) Applicant: SEIKO INSTRUMENTS INC.
31-1, Kameido 6-chome Koto-ku
Tokyo 136(JP)

(72) Inventor: Nakanishi, Shoji c/o Seiko
Instruments Inc.
31-1 Kameido 6-chome
Koto-ku Tokyo(JP)

(74) Representative: Caro, William Egerton et al
J. MILLER & CO. Lincoln House 296-302 High
Holborn
London WC1V 7JH(GB)

(54) **Non-volatile semi-conductor memory device.**

(57) A non-volatile semi-conductor memory device
comprises a substrate (11) of a first conductivity
type, source and drain regions (12,13) formed in a
surface portion of the substrate in spaced apart
relation to one another to define therebetween a
channel region, the source and drain regions being
of opposite conductivity type to that of the substrate,
and a floating gate electrode (15) disposed over a
surface of the semi-conductor substrate (11) between the source and drain regions (12,13) to a gate
insulating film (14). A control gate electrode (17) is
disposed above and electrically insulated from the
floating gate electrode (15) to an insulating film (16).
An erase electrode (19) is disposed above and elec-
trically insulated from the floating gate electrode (15)
to a tunnel insulating film (18), the tunnel insulating
film being comprised of an oxidized nitride film
formed by thermal oxidation of a nitride film.

# F I G. 1

## NON-VOLATILE SEMI-CONDUCTOR MEMORY DEVICE

This invention relates to non-volatile semi-conductor memory devices of the type having a floating gate electrode for storing therein an electric charge to memorise information.

A typical conventional electrically erasable programmable read only memory (hereinafter referred to as an"EEPROM") has a two-layer gate structure including a floating gate electrode made of polycrystalline silicon formed through a first insulating film on a semi-conductor substrate and a control gate electrode formed through a second insulating film on the floating gate electrode. An EEPROM of this type is disclosed in US-A-4,203,158. The EEPROM, for example, includes a semi-conductor substrate of a first conductivity type, e.g. P-type. In the surface portion of the substrate, source and drain regions of a second conductivity type, opposite to that of the first conductivity type, i.e. N-type, are formed. The surface of the semi-conductor substrate is covered by a first insulating film which is formed by thermal oxidation of the surface of the semi-conductor substrate. Since the semi-conductor substrate is made of mono-crystal silicon, the first insulating film is a thin film of $SiO_2$. The floating gate electrode is formed of polycrystalline silicon on the first insulating film. The floating gate electrode is covered by a second insulating film. The second insulating film is covered by a control gate electrode.

An improved example of a conventional EEPROM further comprises an erase gate electrode. US-A-4,503,619 describes such an EEPROM. This EEPROM includes a floating gate electrode formed on a semi- conductor substrate to a first or gate insulating film, and an erase-only or a write/erase gate electrode through a second insulating film on the floating gate electrode. The second insulating film comprises first and second portions. The first portion has a thickness between 150 and 400 angstroms and the thickness is less than that of the second portion.

In a writing operation, a high voltage is applied to a control gate electrode and a drain electrode, while the source region is grounded, and hot electrons which are generated in a channel region are thereby injected into the floating gate electrode comprised of a polycrystalline silicon layer to the first insulating film.

In an erasing operation, a positive higher voltage is applied to the erase only electrode thereby discharging electrons in the floating gate electrode through the first portion of the second insulating film, i.e. a tunnel thermal oxidation film, by Fowler-Nordheim tunnelling.

Information can be read out by making use of the fact that the channel conductance between the source region and the drain region, which work in combination with the floating gate electrode that serves as a gate electrode, changes in accordance with the amount of charge accumulated in the floating gate electrode.

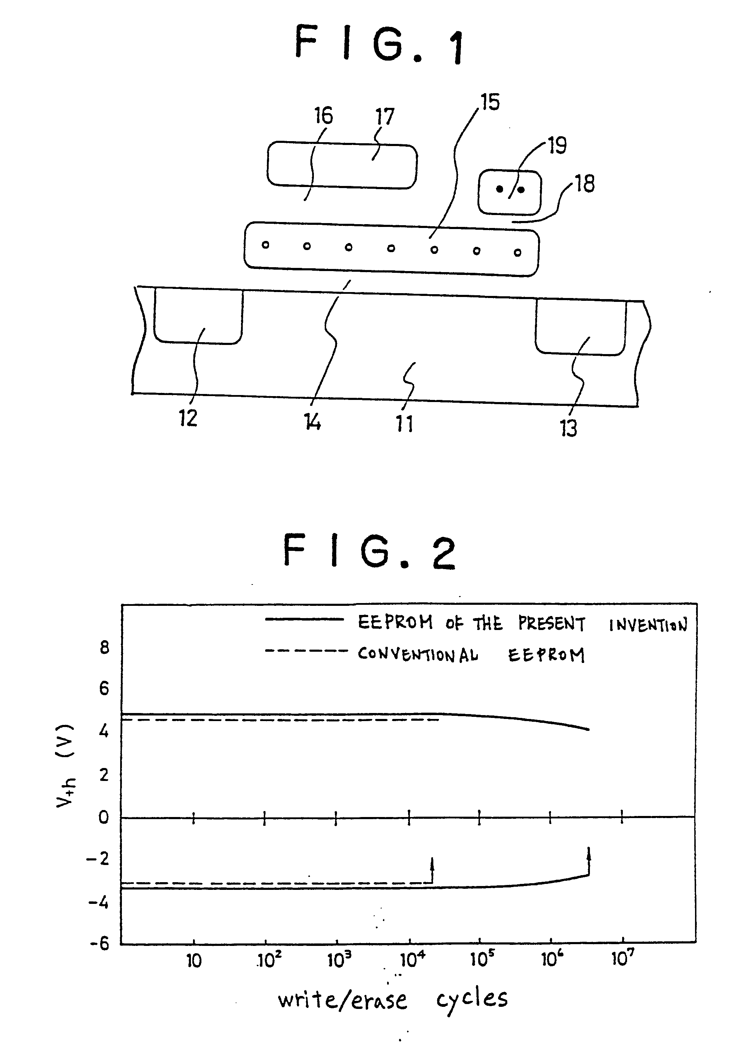

In the case of EEPROM wherein erasing is effected by applying a high electric field to the tunnel thermal oxide film provided over the floating gate electrode as described above,if re-writing is carried out repeatedly, the tunnel thermal oxide film over the polycrystalline silicon layer is deteriorated through wear caused by the application of a high electric field at the time of erasing, which may result in destruction of the EEPROM. For reference, the write/erase charac teristics of the conventional EEPROM are shown by broken lines in Figure 2. In Figure 2, the number of times of programming and erasing is plotted along the abscissa and the threshold voltage (Vth) is plotted along the ordinate.

As shown in Figure 2, the conventional EEPROM becomes useless only after $10^4$ write/erase cycles.

The present invention seeks to provide a non-volatile semi-conductor memory device which does not have the defects of the conventional devices and to provide an improved EEPROM which does not become useless even after $10^6$ write/erase cycles. The present invention also seeks to provide an improved EEPROM which is electrically erasable and programmable with ease and has an enhanced memory reliability.

According to the present invention there is provided a non-volatile semi-conductor memory device characterised by comprising: a substrate of a first conductivity type; source and drain regions formed in the surface portion of the substrate in spaced apart relation to one another to define therebetween a channel region, the source and drain regions being of opposite conductivity type to that of the substrate; a floating gate electrode disposed over a surface of the semi-conductor substrate between the source and drain regions to a gate insulating film; a control gate electrode disposed above and electrically insulated from the floating gate electrode to an insulating film; and an erase electrode disposed above and electrically insulated from the floating gate electrode to a tunnel insulating film, the tunnel insulating film being comprised of an oxidized nitride film formed by thermal oxidation of a nitride film.

The nitride film may be formed by thermal nitridation. Thus the nitride film may be formed by thermal nitridation of the upper surface of the floating gate electrode (15) in a purified ammonia gas atmosphere.

The tunnel insulating film is preferably formed at an oxidation temperature above 950°C.

In one embodiment the tunnel insulating film has a thickness between 100 and 200 angstroms.

The tunnel insulating film may comprise a silicon oxy-nitride film formed by thermal oxidation of polycrystalline silicon in the floating gate electrode.

The invention is illustrated, merely by way of example, in the accompanying drawings, in which:-

Figure 1 is a schematic sectional view of a non-volatile semi-conductor memory device according to the present invention; and

Figure 2 shows write/erase characteristics of the non-volatile semi-conductor memory device of Figure 1 and of a conventional non-volatile semiconductor memory device.

In the present invention, an oxidized nitride film formed by thermal oxidation of a nitride film is employed as a tunnel insulating film for discharging to an erase electrode the charge injected into a floating gate electrode comprised of a polycrystalline silicon layer. An oxidized nitride film formed by thermal oxidation is more resistant to wear deterioration than an oxide film formed by thermal oxidation. That is, the tunnel insulating film comprises an oxidized nitride by thermal oxidation of polycrystalline silicon.

Since an oxidized thermal nitride film provided over polycrystalline silicon is more resistant to wear than a thermal oxide film over polycrystalline silicon and the former is also longer than the latter in terms of lifetime with respect to destruction with time, the resistance to damage at the time of erasing is improved.

Figure 1 is a schematic sectional view of one embodiment of an EEPROM according to the present invention. An $N^+$ source region 12 and an $N^+$ type drain region 13 are formed in the surface of, for example, a P type silicon substrate 11 in spaced apart relation to define therebetween a channel region. A floating gate electrode 15, which is comprised of a polycrystalline silicon layer, is provided through a gate insulating film 14, and further, a control gate electrode 17 for controlling the potential of the floating gate electrode 15 is provided to an insulating film 16. In addition, an erase electrode 19 is provided through a tunnel oxidized nitride film 18 formed by thermal oxidation.

In a writing operation, a high voltage is applied to the control gate electrode 17 an $N^+$ type drain region 13, while the $N^+$ source region 12 is grounded, and hot electrons which are generated in the channel region are thereby injected into the floating gate electrode 15 comprised of a polycrystalline silicon layer through the gate insulating film 14.

In an erasing operation, a positive high voltage is applied to the erase electrode 19 thereby to discharge electrons in the floating gate electrode 15 to the thermally oxidized nitride film 18 by Fowler-Nordheim tunnelling.

Formation of the nitride film 18 that serves as a tunnel insulating film will now be described. The upper surface of the floating gate electrode 15 which is comprised of conductive polycrystalline silicon having phosphorous diffused therein is, for example, heated to a high temperature using a diffusion furnace in purified ammonia gas atmosphere (nitridation), thereby forming a thermal nitride film having a thickness of about 50 angstroms on the upper surface of the floating gate electrode 15, and high temperature heating at 1000°C is further carried out in an oxygen atmosphere at ordinary pressure, thereby forming a tunnel oxidized nitride film 18 having a thickness of about 120 angstroms.

The tunnel oxidized nitride film 18 may have a thickness in the range between 100 and 200 angstroms formed by thermal oxidation of the silicon nitride film at a temperature above 950°C, preferably above 1000°C. The silicon nitride film on the floating gate electrode is thermally oxidized, so that the tunnel oxidized nitride film is formed. The film 18 is an oxidized silicon nitride ($Si_xO_yN_z$) film. The insulating film 16 may have a thickness in the range between 100 to 500 angstroms so that the control gate electrode 17 and the floating gate electrode 15 are coupled capacitively. The film 16 may be of silicon dioxide ($SiO_2$).

The write/erase characteristics of the non-volatile semi-conductor memory device of Figure 1 are shown by solid lines in Figure 2.

As will be clearly understood from Figure 2, the oxidized nitride film has a tunnel insulating film for writing and erasing in a floating gate type EEPROM enables the EEPROM to carry out an increased number of writing and erasing operations, i.e. about $10^6$, which is more than one hundred times that in the case of the prior art EEPROMs.

As described above, the present invention employs the oxidized nitride film as a tunnel insulating film of a floating gate type EEPROM and thereby offers the advantage that the number of possible writing and erasing operations can be increased to about one hundred times that of conventional floating gate EEPROMs which employ a thermal oxide film. Accordingly, the present invention can provide a highly reliable floating gate type EEPROM.

## Claims

1. A non-volatile semi-conductor memory device characterised by comprising: a substrate (11) of a first conductivity type; source and drain regions (12,13) formed in the surface portion of the substrate in spaced apart relation to one another to define therebetween a channel region, the source and drain regions being of opposite conductivity type to that of the substrate; a floating gate electrode (15) disposed over a surface of the semiconductor substrate (11) between the source and drain regions (12,13) to a gate insulating film (14); a control gate electrode (17) disposed above and electrically insulated from the floating gate electrode (15) to an insulating film (16); and an erase electrode (19) disposed above and electrically insulated from the floating gate electrode (15) to a tunnel insulating film (18), the tunnel insulating film being comprised of an oxidized nitride film formed by thermal oxidation of a nitride film.

2. A non-volatile semi-conductor memory device as claimed in claim 1 characterised in that the nitride film is formed by thermal nitridation.

3. A non-volatile semi-conductor memory device as claimed in claim 2 characterised in that the nitride film is formed by thermal nitridation of the upper surface of the floating gate electrode (15) in a purified ammonia gas atmosphere.

4. A non-volatile semi-conductor memory device as claimed in any preceding claim characterised in that the tunnel insulating film (18) is formed at an oxidation temperature above 950 °C.

5. A non-volatile semi-conductor memory device as claimed in any preceding claim characterised in that the tunnel insulating film (18) has a thickness between 100 and 200 angstroms.

6. A non-volatile semi-conductor memory device as claimed in any preceding claim characterised in that the tunnel insulating film (18) comprises a silicon oxynitride film formed by thermal oxidation of polycrystalline silicon in the floating gate electrode (15).

# F I G. 1

# F I G. 2